# EUROPÄISCHE PATENTSCHRIFT

(11) **EP 2 024 979 B1**
(45) Veröffentlichungstag und Bekanntmachung des Hinweises auf die Patenterteilung: **31.12.2014**
(21) Anmeldenummer: 07725695.6
(22) Anmeldetag: 31.05.2007
(51) Int. Cl.: H01F 27/26, H01F 27/33, H03H 1/00

(54) **VORRICHTUNG ZUM ABSORBIEREN DES RAUSCHENS**
DEVICE FOR ABSORPTION OF NOISE
DISPOSITIF POUR ABSORBER LE BRUIT

(30) Priorität: 08.06.2006 DE 102006027312
(43) Veröffentlichungstag der Anmeldung: 18.02.2009
(73) Patentinhaber: Würth Elektronik eiSos GmbH & Co. KG, 74638 Waldenburg (DE)
(72) Erfinder: KONZ, Oliver, 74532 Ilshofen (DE)
(74) Vertreter: Patentanwälte Ruff, Wilhelm, Beier, Dauster & Partner
(86) Internationale Anmeldenummer: PCT/EP2007/004808
(87) Internationale Veröffentlichungsnummer: WO 2007/140918

(56) Entgegenhaltungen:
- EP-A2- 1 039 632
- US-A- 5 003 278

## Beschreibung

Die Erfindung betrifft eine Vorrichtung zum Absorbieren des elektrischen Rauschens auf Kabeln.

Es ist bekannt, dass man die Ausbreitung von elektrischen Störsignalen, auch als Rauschen bezeichnet, auf Kabeln dadurch verhindern kann, dass man das Kabel durch einen entweder vollständig oder fast vollständig geschlossenen Ring aus beispielsweise ferromagnetischem Material hindurch führt. Um dies auch bei vorhandenen Kabeln nachträglich durchführen zu können, sind Vorrichtungen bekannt, bei denen in einem zweischaligen Gehäuse zwei Ringhälften aus ferromagnetischem Material untergebracht sind. Dieses Gehäuse wird um ein Kabel herum geschlossen, so dass sich dann ein geschlossener magnetischer Ring oder ein Ring mit einem kleinen Luftspalt ergibt. Um derartige Vorrichtungen an dem Kabel befestigen zu können, haben die Gehäuse ein Fixiermittel. Dieses Fixiermittel greift an der Isolierung des Kabels an. Es soll verhindern, dass das Gehäuse mit dem ferromagnetischem Material das Kabel entlang rutscht. Beispielsweise ist es bekannt, in einer Öffnung, durch die das Kabel hindurchgeführt ist, Zähne anzuformen, die in das Kabel eingreifen. Bei einer bekannten Vorrichtung dieser Art (EP 257179) sind in jeder Öffnung mehrere derartige Zähne ausgebildet.

Ebenfalls bekannt ist es (DE 19912917), das Kabel in einem Schlitz zwischen zwei Kanten einzuschieben und dort klemmend festzuhalten.

**Weiterhin bekannt ist eine Vorrichtung zum Absorbieren des elektrischen Rauschens auf Kabeln, die ein zweiteiliges Gehäuse mit jeweils einem Ferritelement enthält. An den Stirnseiten des Gehäuses sind an jeder Hälfte mehrere schräg nach außen gerichtete Finger angeformt, die bei geschlossenem Gehäuse mit ihren Enden an dem Kabel anliegen und dadurch das Gehäuse festlegen (**US 5003278**).**

Vorrichtungen dieser Art werden häufig an unterschiedlich dicken Kabeln festgelegt. Es gibt aber auch die Problematik, dass die Kabel bei gleicher Dicke unterschiedlich stark flexibel sind. Dies gilt beispielsweise dann, wenn die Kabel dicke massive Drähte aufweisen. In diesem Fall sind sie weniger flexibel als Kabel mit vielen dünnen Litzen.

Der Erfindung liegt die Aufgabe zu Grunde, eine Vorrichtung zum Absorbieren des elektrischen Rauschens auf Kabeln zu schaffen, die sich an den unterschiedlichsten Arten von Kabeln sicher befestigen lässt.

Zur Lösung dieser Aufgabe schlägt die Erfindung eine Vorrichtung mit dem im Anspruch 1 genannten Merkmalen vor. Weiterbildungen der Erfindung sind Gegenstand von Unteransprüchen.

Die Vorrichtung enthält also ein Gehäuse, in dem das ferromagnetische Material untergebracht ist. Bei dem Gehäuse handelt es sich um ein zweischaliges Gehäuse, ähnlich wie dies im Stand der Technik bekannt ist. Die Verformung der Fixiermittel in Längsrichtung des Kabels macht es möglich, dass bei sehr starren oder auch dicken Kabeln die Fixiermittel ausweichen können, um durch die Verformung ausreichend Reaktionskraft zu entwickeln, die zum Festlegen dient. Je starrer ein Kabel ist, desto mehr Platz steht auch an den Stirnwänden zur Verfügung, da das Kabel dort auch nicht abgeknickt werden kann.

In Weiterbildung der Erfindung **ist** vorgesehen, dass das Fixiermittel auch in Querrichtung des Kabels verformbar ausgebildet ist. Hier kann eine zusätzliche Möglichkeit geschaffen werden, unterschiedliche Flexibilitäten und/oder Kabelgrößen auszugleichen.

In Weiterbildung der Erfindung **ist** vorgesehen, dass das Fixiermittel zwei zwischen sich einen Schlitz bildende Fixierkanten aufweist, zwischen denen das Kabel festlegbar ist. Dies kann entweder so geschehen, dass das Kabel seitlich in den Schlitz hinein gedrückt wird und dadurch festgelegt wird. Wegen der Verformbarkeit in Längsrichtung ist es aber auch möglich, dass das Kabel von der einen Seite her durch das Fixiermittel hindurch geschoben wird, was dann ebenfalls zur Verformung der Fixiermittel führt.

In Weiterbildung der Erfindung kann vorgesehen sein, dass die Fixierkanten an Stegen ausgebildet sind, die etwa parallel zur Stirnseite des Gehäuses verlaufen. Bei den Stegen kann es sich um flache plattenähnliche Elemente handeln. Diese sind an bestimmten Stellen mit den Stirnseiten des Gehäuses verbunden.

Beispielsweise kann in Weiterbildung der Erfindung vorgesehen sein, dass die Stege im Querschnitt L-förmig sind, wobei ein Schenkel parallel zu der Stirnseite des Gehäuses verläuft und die Fixierkante aufweist.

Der andere Schenkel ist vorzugsweise einstückig mit der Stirnseite des Gehäuses verbunden.

Bei einem einseitig offenen Schlitz kann erfindungsgemäß vorgesehen sein, dass die äußeren Enden der Fixierkanten sich in Richtung auf das freie Ende voneinander entfernen.

An einer geschlossenen Seite des Schlitzes kann vorgesehen sein, dass die Fixierkanten in diesem Bereich parallel zueinander verlaufen.

Erfindungsgemäß kann vorgesehen sein, dass an beiden gegenüberliegenden Stirnseiten des Gehäuses jeweils ein Fixiermittel vorhanden ist, das vorzugsweise identisch mit dem anderen Fixiermittel ausgebildet ist.

Weitere Merkmale, Einzelheiten und Vorzüge der Erfindung ergeben sich aus den Ansprüchen, deren Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Figur 1: eine Stirnansicht eines geöffneten Gehäuses;
- Figur 2: eine Ansicht des geöffneten Gehäuses von der geschlossenen Seite der beiden Gehäuseschalen her;
- Figur 3: eine Ansicht des geöffneten Gehäuses von oben in Figur 1;
- Figur 4: eine Seitenansicht des geschlossenen Gehäuses ohne Kabel;
- Figur 5: schematisch eine Draufsicht auf das an einem dicken Kabel festgelegte Gehäuse.

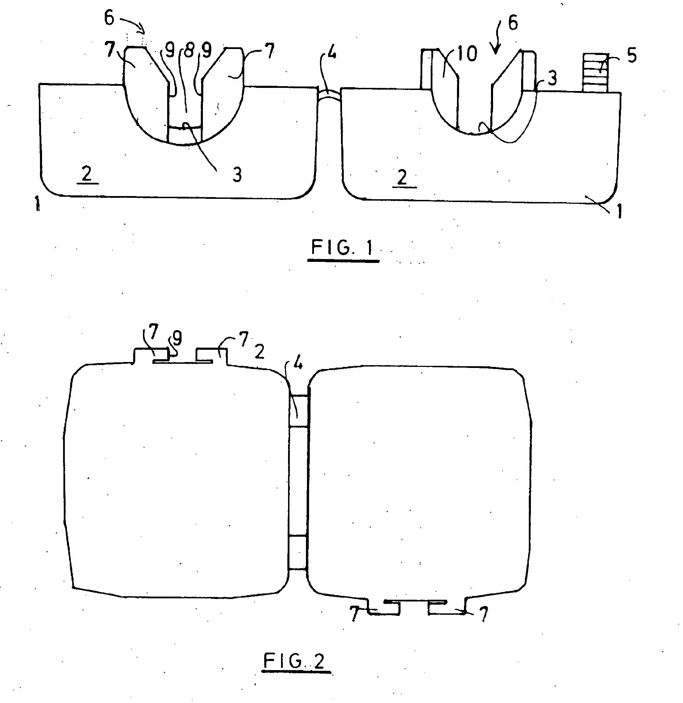

Figur 1 zeigt in einer Stirnansicht ein geöffnetes Gehäuse einer Vorrichtung zum Absorbieren des elektrischen Rauschens auf Kabeln. Das Gehäuse enthält zwei Teilschalen 1, die etwa trogartig ausgebildet sind und in ihren beiden Stirnseiten 2 jeweils eine etwa halbkreisförmige Kerbe 3 aufweisen. Die beiden Halbschalen 1 sind über ein Folienscharnier 4 miteinander verbunden, das im Bereich beider Längskanten ausgebildet ist. An der dem Folienscharnier 4 abgewandten Außenkante weist eine Halbschale einen Vorsprung 5 mit Zähnen auf, die dazu dienen, die geschlossenen Halbschalen 1 in geschlossenem Zustand zu verriegeln.

Im Bereich der in Figur 1 zu sehenden Stirnseite 2 der linken Gehäuseschale ist ein Fixiermittel 6 ausgebildet, insbesondere einstückig aus dem Kunststoff des Gehäuses mitgespritzt. Das Fixiermittel 6 enthält zwei Stege 7, die eine ebene Frontseite aufweisen, die parallel zur Stirnseite 2 der entsprechenden Gehäusehalbschale 1 verläuft. Die beiden Stege weisen einen gegenseitigen Abstand auf, so dass dort ein Schlitz 8 gebildet ist. Die dem Schlitz zugewandten Innenseiten der Stege 8 bilden Fixierkanten 9. Im unteren Bereich in Figur 1, also dort, wo das Ende des Schlitzes 8 durch die Kontur der halbkreisförmigen Kerbe 3 in der Stirnseite 2 des Gehäuses vorhanden ist, verlaufen die Fixierkanten 9 parallel zueinander. In dem Endbereich, also dort, wo der Schlitz 8 offen ist, divergieren die Fixierkanten zur Bildung einer Einführschneise.

An der zweiten Gehäusehalbschale 1, rechts in Figur 1, ist das identische Fixiermittel 6 auf der gegenüberliegenden Seite angeordnet. Hier ist die Rückseite 10 der Stege 7 dargestellt, die eine Stufe bilden, da sie einen Abstand von der Stirnseite 2 der Gehäusehalbschale 1 aufweisen.

Figur 2 zeigt eine Ansicht der Gehäusehalbschalen von unten in Figur 1. Es ist zu sehen, dass zwei mit Abstand ausgebildete Folienscharniere 4 vorhanden sind. Ebenfalls zu sehen ist, dass die Stege 7 im Querschnitt beziehungsweise in der Untenansicht L- Form aufweisen, wobei ein Schenkel der Stege 7 parallel zur Stirnseite 2 verläuft. Der zweite Schenkel dient dazu, den ersten Schenkel mit der Stirnseite 2 einstückig zu verbinden. Man kann der Figur 2 auch entnehmen, dass bei einer Belastung in Längsrichtung, das heißt in Figur 2 von unten nach oben, sich die Fixierkanten 9 nach oben bewegen können, indem sich die Stege 7 verformen.

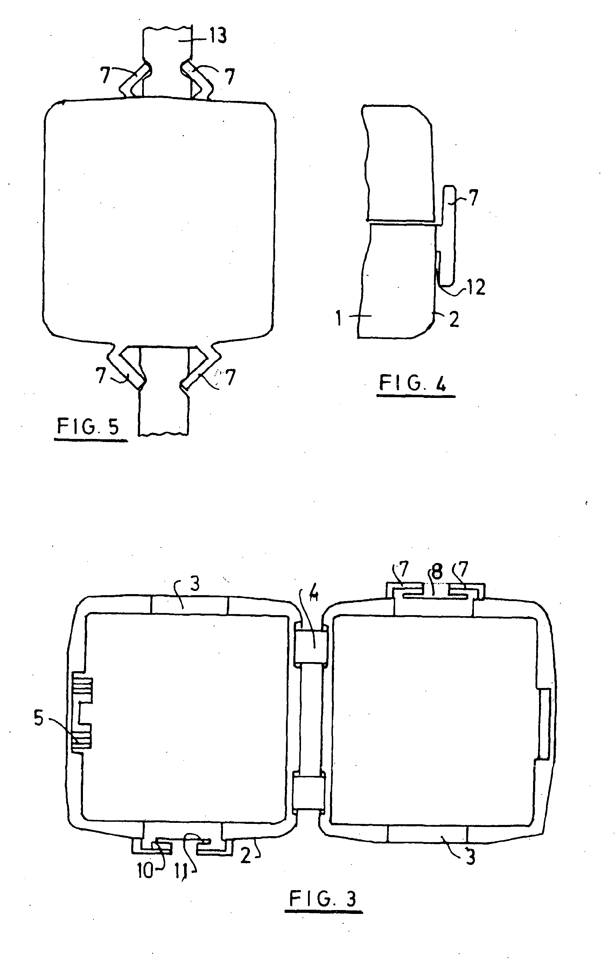

Nun zu Figur 3. Diese zeigt die Anordnung der Figur 1 von oben in Figur 1. Hier ist zu sehen, dass die Stege 7 mit ihren Rückseiten 10 einen Abstand von der Fläche der Stirnseite 2 aufweisen, und dass Einkerbungen beziehungsweise Einschnitte 11 zwischen den Stegen und der Stirnseite 2 vorhanden sind, die es ermöglichen, dass die Stege 7 in Längsrichtung des vorliegenden Kabels verformbar sind.

Figur 4 zeigt eine Seitenansicht des geschlossenen Gehäuses ohne eingelegtes Kabel. Auch in dieser Ansicht ist zwischen den Stegen 7 und der Stirnseite 2 der Gehäusehalbschale 1 ein Einschnitt 12 vorhanden, so dass die Höhe des den Steg 7 mit dem Gehäuse verbindenden Schenkels verringert ist. Auch dies trägt dazu bei, den als plattenähnliches Element ausgebildeten Steg 7 so anzuordnen, dass er durch Verformen des Verbindungselements selbst verformt werden kann, und zwar in einer Weise, dass die Fixierkanten 9 sich in axialer Richtung bewegen können. Unter Axialrichtung ist diejenige Richtung zu verstehen, die die beiden halbrunden Einkerbungen 3 einer Gehäuseschale miteinander verbindet.

Das Ergebnis der Anbringung eines solchen Gehäuses an einem Kabel 13 ist in Figur 5 dargestellt. Es wird angenommen, dass es sich um ein relativ dickes Kabel handelt, dessen Durchmesser deutlicher größer ist als der Abstand der beiden Fixierkanten 9 in ihrem parallelen Bereich voneinander. Dadurch schwenken die Stege 7 von der Stirnseite 2 der Gehäusehalbschale weg, um dadurch den Schlitz 8 zu verbreitern. Gleichzeitig entsteht die Wirkung, dass die Ecken der Fixierkanten 9 eine scharfe Kante bilden, die in das Material der Isolierung des Kabels 13 eingreifen. Man kann der Figur 5 entnehmen, das durch diese Art der Verformung auch dicke und steife Kabel 13 festgelegt werden können, während dünnere oder flexiblere Kabel zu einer geringeren Verformung der Stege 7 führen.

## Patentansprüche

1. Vorrichtung zum Absorbieren des elektrischen Rauschens auf Kabeln (13), mit
1.1 einem **zwei Teilschalen (1) enthaltenden** Gehäuse, das
1.2 in geschlossenem Zustand in beiden Stirnseiten (2) je eine Öffnung (3) für ein hindurchzuführendes Kabel (13) aufweist, sowie mit
1. 3 **mindestens** einem Fixiermittel (6) zum Festlegen des Gehäuses an dem Kabel (13), wobei
1.4 das Fixiermittel (6) im Bereich der Öffnung (3) an mindestens einer Stirnseite (2) **des Gehäuses** an dem Kabel (13) angreift und 1.5 in Längsrichtung **und in Querrichtung** des Kabels (13) verformbar ausgebildet ist,
**dadurch gekennzeichnet, dass**
**1.6 ein Fixiermittel (6) an der Stirnseite nur einer Teilschale (1) und bei Vorhandensein zweier Fixiermittel (6) das zweite Fixiermittel (6) an der gegenüberliegenden Stirnseite des Gehäuses angeordnet ist, und**
1.7 das Fixiermittel (6) zwei zwischen sich einen Schlitz (8) bildende Fixierkanten (9) aufweist, zwischen denen das Kabel (13) festlegbar ist.

2. Vorrichtung nach Anspruch 1, bei dem die Fixierkanten (9) an Stegen (7) ausgebildet sind, die etwa parallel zur Stirnseite (2) des Gehäuses verlaufen.

3. Vorrichtung nach Anspruch 2, bei dem die Stege (7) im Querschnitt L- förmig sind, wobei ein Schenkel der Stege (7) parallel zur Stirnfläche (2) des Gehäuses verläuft und die Fixierkante (9) aufweist.

4. Vorrichtung nach Anspruch 3, bei der der andere Schenkel einstückig mit der Stirnseite (2) des Gehäuses verbunden ist.

5. Vorrichtung nach einem der vorhergehenden Ansprüche, bei der die äußeren Enden der Fixierkanten (9) sich voneinander entfernen.

6. Vorrichtung nach einem der vorhergehenden Ansprüche, bei der die Fixierkanten (9) im Endbereich des Schlitzes (8) parallel zueinander verlaufen.

7. Vorrichtung nach einem der vorhergehenden Ansprüche, bei der ein Fixiermittel (6) an beiden Stirnseiten (2) des Gehäuses ausgebildet ist.

## Claims

1. A device for absorbing electrical noise on cables (13), comprising
1.1 a housing including two half-shells (1) that,
1.2 in the closed state, has on each of two end faces (2) an aperture (3) for a cable (13) to be passed through, and comprising
1.3 at least one fixation means (6) for fixing the housing on the cable (13), wherein
1.4 the fixation means (6) in the vicinity of the aperture (3) engages on the cable (13) on at least one end face (2) of the housing, and
1.5 is designed to be deformable in the longitudinal direction and in the transverse direction of the cable (13),
**characterized in that**
1.6 a fixation means (6) is arranged on the end face of only one half-shell (1) and, in case of two fixation means (6) present, the second fixation means (6) is arranged on the opposite end face of the housing, and
1.7 the fixation means (6) has two fixing edges (9) forming a slot (8) between them and between said fixing edges the cable (13) is fixable.

2. The device according to claim 1, wherein the fixing edges (9) are formed on strips (7) which extend roughly parallel to the end face (2) of the housing.

3. The device according to claim 2, wherein the strips (7) have L-shaped cross-sections, whereby one leg of the strips (7) extends parallel to the end face (2) of the housing and includes the fixing edge (9).

4. The device according to claim 3, wherein the other leg is connected in one piece to the end face (2) of the housing.

5. The device according to any one of the preceding claims, wherein the outer ends of the fixing edges (9) diverge away from one another.

6. The device according to any one of the preceding claims, wherein the fixing edges (9) extend parallel to one another in the end region of the slot (8).

7. The device according to any one of the preceding claims, wherein a fixation means (6) is formed on both end faces (2) of the housing.

## Revendications

1. Dispositif pour absorber le bruit électrique sur des câbles (13), comportant:
1.1 un boîtier contenant deux coquilles partielles (1),
1.2 qui présente à l'état fermé, dans les deux faces frontales (2), respectivement une ouverture (3) pour un câble à y introduire (13), ainsi que
1.3 au moins un moyen de fixation (6) pour fixer le boîtier sur le câble (13), dans lequel
1.4 le moyen de fixation (6) s'accroche au câble (13) dans la région de l'ouverture (3) à au moins une face frontale (2) du boîtier et
1.5 est déformable en direction longitudinale et en direction transversale du câble (13),
**caractérisé en ce que**
1.6 un moyen de fixation (6) est disposé à la face frontale d'une seule coquille partielle (1) et, en cas de présence de deux moyens de fixation (6), le deuxième moyen de fixation (6) est disposé à la face frontale opposée du boîtier, et
1.7 le moyen de fixation (6) présente deux bords de fixation (9) formant une fente (8) entre eux et entre lesquels le câble (13) peut être fixé.

2. Dispositif selon la revendication 1, dans lequel les bords de fixation (9) sont formés sur des pattes (7), qui sont sensiblement parallèles à la face frontale (2) du boîtier.

3. Dispositif selon la revendication 2, dans lequel les pattes (7) ont une section transversale en forme de L, dans lequel une branche des pattes (7) est parallèle à la face frontale (2) du boîtier et présente le bord de fixation (9).

4. Dispositif selon la revendication 3, dans lequel l'autre branche est reliée d'un seul tenant à la face frontale (2) du boîtier.

5. Dispositif selon l'une quelconque des revendications précédentes, dans lequel les extrémités extérieures des bords de fixation (9) s'éloignent l'une de l'autre.

6. Dispositif selon l'une quelconque des revendications précédentes, dans lequel les bords de fixation (9) s'étendent parallèlement l'un à l'autre dans la région d'extrémité de la fente (8).

7. Dispositif selon l'une quelconque des revendications précédentes, dans lequel un moyen de fixation (6) est formé sur les deux faces frontales (2) du boîtier.
